# EUROPEAN PATENT SPECIFICATION

(11) **EP 4 639 439 B1**
(45) Date of publication and mention of the grant of the patent: **21.10.2026**
(21) Application number: 23833124.3
(22) Date of filing: 19.12.2023
(51) Int. Cl.: G06Q 10/063, G06Q 10/0631, G06Q 10/0637, G06Q 10/08, B60L 58/16, B60L 53/80, G01R 31/392, G08G 1/00

(54) **SYSTEM AND METHOD FOR IMPROVING UTILIZATION OF ELECTRICAL ENERGY STORAGE PACKS**
VERFAHREN UND SYSTEM ZUR STROMSPEICHERWARTUNG AUF FLOTTENEBENE
PROCÉDÉ ET SYSTÈME DE MAINTENANCE DE STOCKAGE D'ÉNERGIE ÉLECTRIQUE AU NIVEAU D'UNE FLOTTE

(30) Priority: 19.12.2022 EP 22214595
(43) Date of publication of application: 29.10.2025
(73) Proprietor: VOLVO TRUCK CORPORATION, 405 08 Göteborg (SE)
(72) Inventor: ALTAF, Faisal, 421 43 VÄSTRA FRÖLUNDA (SE)
(74) Representative: Kransell & Wennborg KB
(86) International application number: PCT/EP2023/086627
(87) International publication number: WO 2024/133249

(56) References cited:
- WO-A1-2021/213654
- US-A1- 2015 127 425
- US-A1- 2022 334 190
- US-B1- 9 079 505
- US-B2- 10 006 967

## Description

### TECHNICAL FIELD

The disclosure relates generally to electrical energy storage systems. In particular aspects, the disclosure relates to a system and method for improving utilization of electrical energy storage packs. The disclosure can be applied to heavy-duty vehicles, such as trucks, buses, construction equipment, and marine vessels, among other vehicle types as well as stationary applications. Although the disclosure may be described with respect to a particular vehicle, the disclosure is not restricted to any particular vehicle.

### BACKGROUND

Electrical energy storage systems are becoming a more common source of energy for providing propulsion power to vehicles. Such electrical energy storage systems have multiple rechargeable electrical energy storage packs connected in series and/or in parallel. In addition, each of the packs consisting of several electrical energy storage cells that may be connected in series and/or in parallel forming a complete electrical energy storage system for the vehicle.

Electrical energy storage systems are inevitably exposed to ageing, which means that they will lose some of their energy and power capability. In some applications, this means that all or some of the electrical energy storage systems must be replaced after some time. Since the condition of the electrical energy storage systems significantly affect the operation capability of a vehicle, it is of high importance that the replacement is made in an effective manner so that vehicle down-time can be reduced. As example of background art, WO 2021/213654 A1 discloses monitoring battery ageing and state of health of a battery in a battery pack of an electric bus to predict end of life and recommend actions. US 2022/334190 A1 discloses forecasting end of life of batteries in a vehicle battery pack and taking actions such as adjusting temperature, power out-take, and charging parameters of the energy storage. US 9 079 505 B1 is concerned with improving the accuracy of battery life prediction in fleet management. US 10 006 967 B2 concerns end-of-life detection for a reconfigurable battery pack. US 2015/127425 A1 concerns a business method for optimising utility services and grid-tied energy assets.

### SUMMARY

The invention is defined by the appended claims 1-15. According to a first aspect of the disclosure, there is provided a computer system for improving utilization of electrical energy storage packs, the system comprising processing circuitry configured to: determine a present state of health, SOH, of each of the electrical energy storage packs, determine a present aging rate of the electrical energy storage packs based on historical usage pattern data of the respective electrical energy storage pack, predict remaining useful life for the respective electrical energy storage pack based on a difference between the present state of health and a lower state of health threshold/limit, and the determined aging rate of the respective electrical energy storage pack, compare the remaining useful life to a lifetime target for each electrical energy storage pack, wherein: if the predicted remaining useful life is below the lifetime target by more than a first predetermined margin, determine that the electrical energy storage pack is over-utilized, and if the predicted remaining useful life exceeds the lifetime target by more than a second predetermined margin, determine that the electrical energy storage pack is under-utilized, provide output data indicating the electrical energy storage packs which are over-utilized, and the electrical energy storage packs which are under-utilized, and their respective state of health's, determine an electrical energy pack storage pack strategy for the over-utilized and under-utilized electrical energy storage packs, the strategy is subject to a predetermined utilization objective, and provide an output message indicating the electrical energy storage pack strategy.

The first aspect of the disclosure may seek to diagnose whether an electrical energy storage pack is best utilized in its present application or if it may be better used in another application. A technical benefit may include improved utilization of electrical energy storage packs subject to a predetermined utilization objective.

The strategy may include for the electrical energy storage packs to maintain in a current application and/or for use in another application.

The lower state of health threshold or limit may be the state of health at which performance requirements for a vehicle using the electrical energy storage pack are not met. The performance requirements may be related to the mission(s) of the vehicle. That is, if the state of health is below or at the lower state of health threshold or limit, the performance requirements are no longer met.

Optionally in some examples, including in at least one preferred example, the predetermined utilization objective may be to minimize aging rate for the electrical energy storage packs. Minimizing aging rate may be for a predetermined time duration not necessarily for the entire lifetime of the electrical energy storage packs. A technical benefit may include increased lifetime for the electrical energy storage packs.

Optionally in some examples, including in at least one preferred example, the predetermined utilization objective may be to maximize the lifetime of the electrical energy storage packs. A technical benefit may include increase lifetime for the electrical energy storage packs.

Lifetime may be in units of time. Alternatively, lifetime may be in units of total energy throughput.

Optionally in some examples, including in at least one preferred example, the predetermined utilization objective may be to minimize the remaining allowable capacity fade at the end of a predetermined time duration. A technical benefit may include to increase available power or capacity at a given time point for the electrical energy storage pack. A further benefit may be to increase the lifetime of the electrical energy storage packs, especially for applications involving vehicles with higher requirements on energy performance and power performance.

Optionally in some examples, including in at least one preferred example, the predetermined utilization objective may be to minimize the remaining allowable increase in internal resistance at the end of a predetermined time duration. A technical benefit may include to increase available power or capacity at a given time point for the electrical energy storage pack. A further benefit may be to increase the lifetime of the electrical energy storage packs. This is especially relevant to applications involving vehicles with higher requirements on energy performance and power performance.

Optionally in some examples, including in at least one preferred example, the predetermined utilization objective may be to minimize a weighted sum of the remaining allowable increase in internal resistance and the remaining allowable capacity fade at the end of the predetermined time duration. A mixed objective function may provide further improved utilization of the electrical energy storage packs by combining more than one parameter. This is especially relevant to applications involving vehicles with higher requirements on energy performance and power performance.

According to the invention, at least a portion of the electrical energy storage packs is utilized in electrified vehicles. Thus, a fleet of vehicles may be considered, optionally mixed with secondary applications for the electrical energy storage packs.

There is further provided a server comprising the computer system of any of the herein disclosed examples.

According to a second aspect of the disclosure, there is provided a computer-implemented method for improving utilization of electrical energy storage packs, the method comprises: determining, by processing circuitry of a computer system, a present state of health, SOH, of each of the electrical energy storage packs, determining, by the processing circuitry, a present aging rate of the electrical energy storage packs based on historical usage pattern data of the respective electrical energy storage pack, predicting, by the processing circuitry, remaining useful life for the respective electrical energy storage pack based on a difference between the present state of health and a lower state of health threshold or limit, and the determined aging rate of the respective electrical energy storage pack, comparing, by the processing circuitry, the remaining useful life to a lifetime target for each electrical energy storage pack, wherein: if the predicted remaining useful life is below the lifetime target by more than a first predetermined margin, determining, by the processing circuitry, that the electrical energy storage pack is over-utilized, an if the predicted remaining useful life exceeds the lifetime target by more than a second predetermined margin, determining, by the processing circuitry, that the electrical energy storage pack is under-utilized, providing, by the processing circuitry, output data indicating the electrical energy storage packs which are over-utilized, and the electrical energy storage packs which are under-utilized, and their respective state of health's, determining, by the processing circuitry, an electrical energy pack storage pack strategy for the over-utilized and under-utilized electrical energy storage packs (in the present or different application), the strategy is subject to a predetermined utilization objective, and providing, by the processing circuitry, an output message indicating the electrical energy storage pack strategy.

The second aspect of the disclosure may seek to diagnose whether an electrical energy storage pack is best utilized in its present application. A technical benefit may include improved utilization of electrical energy storage packs subject to a predetermined utilization objective.

Optionally in some examples, including in at least one preferred example, the predetermined utilization objective may be to minimize aging rate for the electrical energy storage packs. A technical benefit may include increase lifetime for the electrical energy storage packs.

Optionally in some examples, including in at least one preferred example, the predetermined utilization objective may be to maximize the lifetime of the electrical energy storage packs. A technical benefit may include increase lifetime for the electrical energy storage packs.

Lifetime may be in units of time. Alternatively, lifetime may be in units of total energy throughput.

Optionally in some examples, including in at least one preferred example, the predetermined utilization objective may be to minimize the remaining allowable capacity fade at the end of a predetermined time duration. A technical benefit may include to increase available power or capacity at a given time point for the electrical energy storage pack. A further benefit may be to increase the lifetime of the electrical energy storage packs.

Optionally in some examples, including in at least one preferred example, the predetermined utilization objective may be to minimize the remaining allowable increase in internal resistance at the end of a predetermined time duration. A technical benefit may include to increase available power or capacity at a given time point for the electrical energy storage pack. A further benefit may be to increase the lifetime of the electrical energy storage packs.

Optionally in some examples, including in at least one preferred example, the predetermined utilization objective may be to minimize a weighted sum of the remaining allowable increase in internal resistance and the remaining allowable capacity fade at the end of the predetermined time duration. Thus, a mixed objective function is provided to provided further improved utilization of the electrical energy storage packs.

Optionally in some examples, including in at least one preferred example, determining the electrical energy pack storage pack strategy comprises: determining, by the processing circuitry, a first predicted remaining useful life for the over-utilized and under-utilized electrical energy storage packs in their present applications, determining, by the processing circuitry, a second predicted remaining useful life for the over-utilized and under-utilized electrical energy storage packs in at least one other application, comparing, by the processing circuitry, the first predicted remaining useful lives and the second predicted remaining useful lives, and determining the electrical energy storage pack strategy based on the comparison. A technical benefit includes better utilization of some electrical energy storage packs in secondary applications. The primary application may be as traction electrical energy stage acks in vehicles.

Optionally in some examples, including in at least one preferred example, the method may comprise: determining, by the processing circuitry, the electrical energy storage pack strategy for a current application with the predetermined utilization objective to minimize a weighted sum of the remaining allowable increase in internal resistance and the remaining allowable capacity fade at the end of the predetermined time duration, for the electrical energy storage packs.

There is further provided a computer program product comprising program code for performing, when executed by the processing circuitry, the method of any of the examples.

There is further provided a non-transitory computer-readable storage medium comprising instructions, which when executed by the processing circuitry, cause the processing circuitry to perform the method of any of the examples.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

**FIG. 1** is an exemplary system diagram of a computer system according to an example.
**FIG. 2** is a block diagram of an electrical energy storage system, ESS, dynamic prediction model according to an example.
**FIG. 3** illustrates one possible application for electrical energy storage packs in the form of in a vehicle according to an example.
**FIG. 4** is another view of **FIG. 1****,** according to an example.
**FIG. 5** is a flow chart of an exemplary method for improving utilization of electrical energy storage packs according to an example.
**FIG. 6** is a schematic diagram of an exemplary computer system for implementing examples disclosed herein, according to an example.

### DETAILED DESCRIPTION

The detailed description set forth below provides information and examples of the disclosed technology with sufficient detail to enable those skilled in the art to practice the disclosure.

Electrical energy storage systems typically include multiple electrical energy storage packs. In electrified vehicles such electrical energy storage systems are utilized for providing traction power or energy, typically by connecting the electrical energy storage packs in parallel to a voltage bus connected to at least one electric machine of the vehicle. The electrical energy storage packs age at different rates depending on the application or the harshness of the missions of the vehicles. Electrical energy storage packs are not only costly, but they may also cause unwanted environmental impact during manufacturing. It is therefore of interest to prolong the lifetime or improve the utilization of the electrical energy storage packs as much as possible.

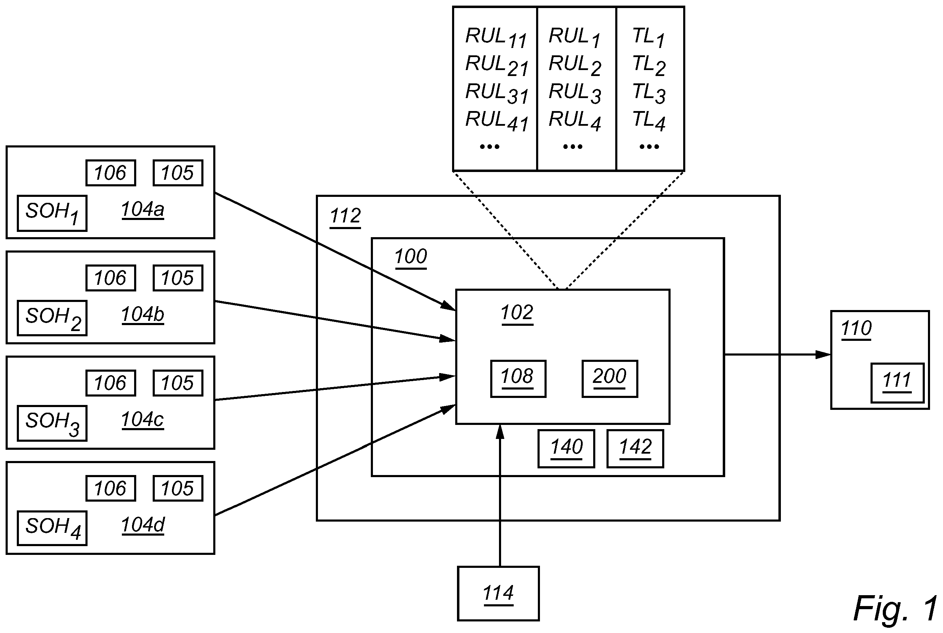

**FIG. 1** is an exemplary system diagram of a computer system 100 comprising processing circuitry 102 according to an example.

The processing circuitry 102 is configured to determine a present state of health, SOH, of each of a plurality of electrical energy storage packs 104a-d. The SOH data may be retrieved from management units of the corresponding electrical energy storage systems of the individual electrical energy storage packs 104a-d or the processing circuitry 102 may calculate the SOH based on measurement data retrieved from sensors of the electrical energy storage packs 104a-d. Such sensors 105 may be voltage, temperature, and/or electric current sensors for detecting a voltage of each electrical energy storage pack 104a-d, or each cell of the electrical energy storage packs 104a-d, or an electrical discharge of each electrical energy storage pack and/or a charge current of each electrical energy storage pack 104a-d, or each cell of the electrical energy storage packs 104a-d. The sensors 105 may also include temperature sensors for measuring a temperature of each electrical energy storage pack 104a-d. Data from the sensors 105 may be used for estimating e.g., SOC, SOH, SOP, SOE, SOQ, etc. by management systems of the electrical energy storage packs 104a-d.

The number of electrical energy storage packs is here selected for clarity and the number of electrical energy storage packs is typically higher than the herein depicted.

State of health may be defined as the loss in capacity relative to a capacity at the beginning of life of the electrical energy storage pack, or the internal resistance increase of the electrical energy storage pack relative to the internal resistance at the beginning of life of the electrical energy storage pack. Further, state of health may equally be defined of loss in range, loss in peak acceleration capability, efficiency loss, loss in power-ability etc.

State of health parameters that may be measured for determining a state of health may include at least a state of capacity, a state of resistance, and/or state of power of the electrical energy storage pack. These state of health parameters are well established and advantageously relatively straight-forward to measure and are typically available from automotive electrical energy storage pack management systems (BMS).

The processing circuitry 102 is further configured to determine a present aging rate of the electrical energy storage packs 104a-d based on historical usage pattern data 106 of the respective electrical energy storage pack 104a-d. The historical usage pattern data 106 may include electric current output, charging history, power output, state of charge data, temperature data, and other data that indicates the usage of the electrical energy storage pack 104a-d. The historical usage pattern data 106 may be correlated with SOH of the electrical energy storage pack 104a-d to in this way determining the present aging rate, that is, by which rate does e.g., SOH presently deteriorate.

State of charge, SOC, which is mentioned herein is the present level of charge in the electrical energy storage compared to its full capacity and may be given as a percentage value.

Target performance requirements for missions of an applications may be historical logged vehicle drive pattern data or usage data regarding actual usage or driving pattern for a mission, and/or data thereof may be provided by a user or client regarding a vehicle's intended use. The vehicle drive pattern data may be used as input to a classification algorithm to perform classification of the vehicle usage pattern for a given mission. For example, vehicle usage pattern can be classified into "benign/mild", "moderate, or "aggressive". Other types of classifications are also conceivable such as classification according to performance requirements to complete a certain mission or set of missions for the vehicle. Example performance requirements include peak acceleration, average acceleration, top speed, range, uphill capability, downhill retardation braking capability, charging time capability, overtaking capability, total cargo weight carrying capability etc. In some implementations the classification can also be made according to vehicle type, e.g., construction truck, city distribution truck, reuse collection truck, flat road truck, hilly truck etc. As an example, using the logged vehicle data, the usage pattern is related to a "high/medium/low" peak acceleration, or any one of the other performance requirements.

The processing circuitry 102 is further configured to predict remaining useful life, RUL1, RUL2, RUL3, RUL4, for the respective electrical energy storage packs based on a difference between the present state of health and a lower state of health threshold/limit, below which limit or threshold, target performance requirements for the present application are not met, and the determined aging rate of the respective electrical energy storage pack. That is, the difference between the present state of health and the limit provides a range of "available" state of health. By evaluating the available state of health in view of the present aging rate, for example, in a simple example by dividing the available state of health by the aging rate, the remaining useful life can be calculated. The remaining useful life may be units of time or in units of remaining energy throughput.

The processing circuitry 102 compares the remaining useful life RUL1, RUL2, RUL3, RUL4, to a lifetime target, TL1, TL2, TL3, TL4, for each electrical energy storage pack 104a-d.

If the predicted remaining useful life RUL1, RUL2, RUL3, RUL4 is below the lifetime target TL1, TL2, TL3, TL4 by more than a first predetermined margin, the processing circuitry determines that the electrical energy storage pack is over-utilized. In other words, if the remaining lifetime of the electrical energy storage pack is less than the target, the electrical energy storage pack is aging too quickly and is thus over-utilized. The first predetermined margin provides an acceptable deviation from the target and may be calibrated based on the present application but is typically one or a few percent of the target.

If the predicted remaining useful life RUL1, RUL2, RUL3, RUL4 exceeds the lifetime target TL1, TL2, TL3, TL4 by more than a second predetermined margin, the processing circuit determines that the electrical energy storage pack is under-utilized. That is, if the remaining lifetime of the electrical energy storage pack is more than the target, the electrical energy storage pack has capacity to be utilized more and is thus under-utilized. The second predetermined margin provides an acceptable deviation from the target and may be calibrated based on the present application but is typically one or a few percent of the target.

The processing circuitry 102 provides data 108 indicating the electrical energy storage packs 104a which are over-utilized, and the electrical energy storage packs 104b-d which are under-utilized, and their respective state of health's SOH1, SOH2, SOH3. That is, the data 108 may include a list of identification numbers for the over-utilized electrical energy storage packs 104a associated with the state of health SOH1, and identification numbers for the under-utilized electrical energy storage packs 104b-c associated with the state of health's SOH2 and SOH3.

The processing circuitry 102 utilizes the data 108 to determine an electrical energy pack storage pack strategy 111 for the over-utilized and under-utilized electrical energy storage packs, in the present application or in a different application. The strategy is subject to a predetermined utilization objective. A strategy includes distributing the electrical energy storage packs 104a-d in different vehicles or in different secondary applications such that the predetermined utilization objective is fulfilled as closely as possible. The predetermined utilization objective may be of different types which will be discussed in more detail below.

Once the electrical energy storage pack strategy is determined, the processing circuitry provides an output message 110 indicating the electrical energy storage pack strategy 111.

A constraint is that the missions of the present application of electrical energy storage packs must be able to be completed using the electrical energy storage packs according to the strategy.

The computer system 100 may be comprised in a server 112 accessible by a local computer.

The computer system 100 further has access to a computer program product 140 and a non-transitory computer-readable storage medium 142.

The processing circuitry 102 determines a strategy for applying the under- and over-utilized electrical energy storage packs 104a-c in missions of the present application, or, applying the under- and over-utilized electrical energy storage packs 104a-c in other applications, such that the predetermined utilization objective for the electrical energy storage packs 104a-c is fulfilled.

To determine the strategy, the processing circuitry 102 may retrieve data 114 indicating energy and power requirements for each of a set of missions where the electrical energy storage devices 104a-c may be applied. The missions may be the missions of a fleet of vehicles. The mission of the fleet includes a set of different missions with different energy and power requirements. An application is herein for example to be used in vehicles or in a secondary application such as stationary or industrial applications. One application is associated with a set of missions.

Advantageously, the fleet missions include a mix of different missions for different vehicles in the fleet to allow flexibility to do optimization. A mission is set by the energy and power required to take a given cargo from an origin to a destination over a given time duration. A mission may further be defined by the frequency and duration of operations, i.e., how often a given mission is performed and the time duration of the missions.

To determine the strategy, the processing circuitry 102 may iterate through all possible configurations of electrical energy storage packs for each mission or application. For example, each mission requires a certain power and energy, typically associated with a number of electrical energy stage packs. The processing circuitry 102 calculates performance including the remaining useful life for the under- and over-utilized electrical energy storage packs 104a-c in its present mission and in each of alternative missions or secondary applications. The performance includes evaluation in view of the predetermined utilization objective. The processing circuitry 102 selects the one configuration of electrical energy storage packs, that is, the electrical energy storage packs to be used for a mission and/or application, such that the missions can be completed while fulfilling the predetermined utilization objective.

In one example, the processing circuitry 102 determines a first predicted remaining useful life, RUL1 (RUL2, RUL3, RUL4) for each of the over-utilized and under-utilized electrical energy storage packs in their present applications. Further, the processing circuitry 102 determines a second predicted remaining useful life RUL_11 (RLTL21, RUL31, RUL41) for each of the over-utilized and under-utilized electrical energy storage packs in at least one other application.

By a straightforward comparison between the first predicted remaining useful lives and the second predicted remaining useful lives performed by the processing circuitry 102, the electrical energy storage pack strategy can be determined. In other words, the processing circuitry predicts the remaining useful life for the electrical energy storage packs 104a-d if they are maintained in their present applications, and the remaining useful life for the electrical energy storage packs 104a-d if they are moved to a different application. If the first predicted remaining useful life, RUL1, is less than the second predicted remaining useful life, RUL11, then the strategy may be to move the said electrical energy storage pack to the second application. If the opposite occurs, RUL1> RUL11, the electrical energy storage pack may instead be maintained in its present application. The predetermined utilization objective should, however, still be fulfilled. It is envisaged that in this particular case, the predetermined utilization objective to minimize a weighted sum of the remaining allowable increase in internal resistance and the remaining allowable capacity fade at the end of a predetermined time duration, for the electrical energy storage packs.

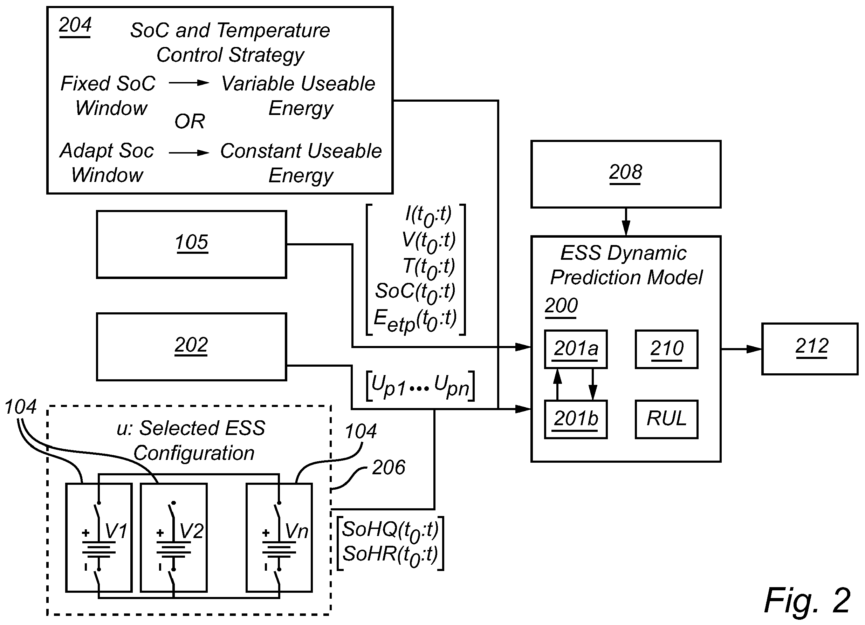

**FIG. 2** is a block diagram of an electrical energy storage system, ESS, dynamic prediction model 200 utilized by the processing circuit 102. The ESS dynamic prediction model 200 receives as input historical usage pattern data 105 including for example historical, from time t0 to time t: electrical currents I, voltages V, temperature T, state of charge SoC, and total energy throughput, Eₑₜₚ from an initial time to a current time. The dynamic prediction model 200 further receives usage pattern data 202, discussed above, for alterative applications or missions for the electrical energy storage packs 104. The usage pattern data 202 indicates an electric load profile, Up, for each of a set of applications or missions.

Optionally, a state of charge control strategy and temperature window control strategy 204 is provided as input. This strategy 204 may indicate the allowable SoC window and allowable temperature window for the electrical energy storage packs 104, which sets some limits to the usable energy in the electrical energy storage packs 104 and also affect the aging rate of the electrical energy storage packs 104.

The ESS dynamic prediction model 200 further receives a configuration (*u*) 206 of electrical energy storage packs 104 to evaluate along with the capacity fade, SOH_{Q} and state of resistance, SOH_{R} from time t0 to present time t. The configuration is a combination of electrical energy storage packs 104. In addition, the present predetermined utilization objective 208 is received by the ESS dynamic prediction model 200. Each electrical energy storage pack 104 is able to output a respective voltage V1, V2,..Vn.

The ESS dynamic prediction model 200 utilizes modules for modelling multi-electrical energy storage electro-thermal dynamics 201a and aging dynamics 201b of electrical energy storage cells. The ESS dynamic prediction model 200 is configured to determine the impact on power and energy performance of the electrical energy storage packs 104 for the given usage data 105 and 202. The impact is quantified for a short time window for the given data 105 and 202 as well as for more long-time windows for effects on aging due to long term usage.

Multi-electrical energy storage system dynamic models 200 may be realized in different ways, but can take as input, the type of electrical energy storage packs in terms of cell chemistry, and their present state of health, and provides an output of how the power is split or shared between electrical energy storage packs, and the total power and energy that can be obtained therefrom. An electrical energy storage pack may be generally modelled as an equivalent circuit of electrical components such as a resistor in series with a parallel connected capacitor and second resistor. Several such parallel circuits may be connected in series. Several such electrical energy storage packs may be connected in parallel to simulate a multi-electrical energy storage system. A dynamic model of a multi-electrical energy storage system can be developed using various approaches including equivalent circuit, electrochemical, empirical, semi-empirical etc. The model can be mathematically represented in the form of differential equations, transfer functions, state-space form etc. The model is used for electro-thermal simulation of any multi-electrical energy storage system, providing: prediction of current/power split between electrical energy storage packs in electrical energy storage systems i.e., prediction of current flow through each electrical energy storage pack for a given total energy storage system current, prediction of temperature evolution for each pack under given coolant flow and predicted current flow, prediction of SoC evolution for each electrical energy storage pack under predicted current flow, in-rush current prediction through each electrical energy storage pack under connection on the fly. Such a multi-electrical energy storage system dynamic model may be configurable for any number of batteries along with individual setting of ageing level, state-of-capacity (SoQ) and state-of-resistance (SoR), for each electrical energy storage pack. In addition, cable connection resistance can be specified for each electrical energy storage pack. The model may also be particularly useful for estimating overall SoP and SoE for heterogeneous ESS. As a reference, the disclosures EP2019/086833, EP2019/086835, EP2020/066874, and EP2020/066919, describe variations of such a multi-electrical energy storage system dynamic model.

Evaluating power split, or load sharing between the electrical energy storage packs may include to estimate energy and power de-rating using a multi-battery system dynamic model. Using the multi-battery system dynamic model allows for analyzing the impact on energy and power capability of a new electrical energy storage system configuration after a certain replacement decision where a combination of replacement electrical energy storage packs and maintained electrical energy storage packs are included. A multi-battery system dynamic model, as discussed above, is configured to model power sharing/split dynamics between different electrical energy storage packs in the electrical energy storage system. Since total available energy and power capability of multi-battery electrical energy storage systems depends on this power sharing/split dynamics among battery packs (in addition to their individual energy and power capabilities), and thus affect an estimated total available energy and power capability of the multi-battery electrical energy storage system. Understanding the power split further improves the determining the aging rate of electrical energy storage packs. Furthermore, the aging rate of a candidate replacement electrical energy storage pack may be determined with higher accuracy.

Evaluating load sharing or power split between the electrical energy storage packs may further be based on other types of models or even look-up tables where given combinations of electrical energy storage packs are related to minimum state of health levels and load distribution parameters. Further types of models or estimations are also envisaged.

The ESS dynamic prediction model 200 predicts power ability and useable energy 210 and remaining useful life, RUL, which are used for evaluating if the present predetermined utilization objective 208 can be fulfilled.

The processing circuitry 102 utilizes the ESS dynamic prediction model 200 to iterate through all possible configurations 206 of electrical energy storage pack 104. The one most suitable configuration, 212, determined from the model 200 is output as the strategy 111 in the message 110.

In a first example, the predetermined utilization objective 208 is to minimize aging rate for the under- and over-utilized electrical energy storage packs 104a-c. That is, the aging output from the ageing dynamic model 201b should be minimized. Consequently, the one configuration 206 that minimizes the ageing rate while the missions of the applications can be fulfilled is selected for the output message 110.

In a second example, the predetermined utilization objective 208 is to maximize the lifetime of the electrical energy storage packs. The lifetime may be in in units of time, e.g., years of operation, formulated as max $\left[{t}_{l}^{EoL}\right]$*,* where EoL is end of life and t is time. The lifetime may equally well be in terms of total energy throughput or number of cycles, formulated as max $\left[{E}_{etp}^{EoL}\right]$.

In a third example, the predetermined utilization objective is to minimize the remaining allowable capacity fade at the end of a predetermined time duration. In other words, the predetermined objective is to min $\left[\left|{SOH}_{q}^{Eot}-{SOH}_{q}^{EoL}\right|\right]$*,* where Eot is end of time duration and q indicates SOH with regards to capacity fade.

Remaining allowable capacity fade means the capacity fade that is allowed from a capacity threshold corresponding to end-of-time (EoT) period, such as a predetermined end-of-time, to end-of-life capacity threshold. For example, if capacity threshold at EoTis 80% and EoL threshold is 70% then remaining allowable capacity fade is 10%. Note that the remaining allowable capacity fade is one of the inputs to calculate RUL prediction i.e., for a given remaining capacity fade and usage pattern we can calculate RUL in terms of time or energy-throughput (ETP). The end-of-time period may be set according to a presently desirable target.

In a fourth example, the predetermined utilization objective is to minimize the remaining allowable increase in internal resistance at the end of a predetermined time duration. In other words, the predetermined objective is to min $\left[\left|{SOH}_{r}^{Eot}-{SOH}_{r}^{EoL}\right|\right]$*,* where Eot is end of time duration and r indicates SOH with regards to internal resistance.

In a fifth example, the predetermined utilization objective is to minimize a weighted sum of the remaining allowable increase in internal resistance and the remaining allowable capacity fade at the end of the predetermined time duration. In other words, the predetermined objective is to min $\left[{α}_{1}\left|{SOH}_{q}^{Eot}-{SOH}_{q}^{EoL}\right|+{α}_{2}\left|{SOH}_{r}^{Eot}-{SOH}_{r}^{EoL}\right|\right]$*,* where the weights *α*₁, *α*₂ are set to give the desired importance to either the capacity fade and internal resistance growth.

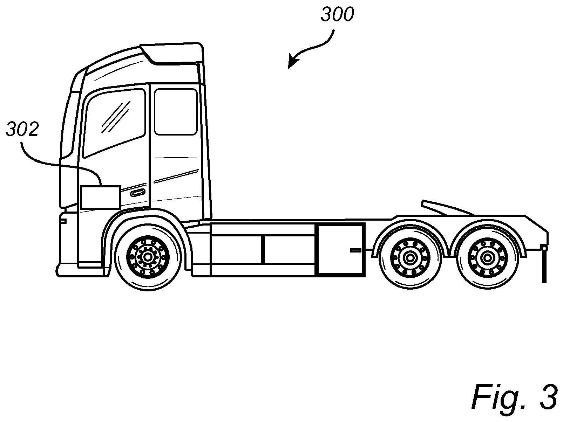

**FIG. 3** illustrates one possible application for electrical energy storage packs 104 being in a vehicle in the form of an electrical truck 300 comprising a propulsion electrical energy storage system 302 generally comprising a plurality of parallel connected electrical energy storage packs including series and/or parallel connected electrical energy storage cells. The propulsion electrical energy storage system 302 is arranged to provide power to an electrical engine (not shown) arranged for providing propulsion for the electrical truck 300. The electrical truck 300 further comprises an electrical energy storage managing system 304 which is configured to monitor electrical energy storage cell characteristics such as state of charge (SOC), state of health (SOH), state of power (SOP), state of energy (SOE), state of capacity (SOQ), etc., electrical energy storage voltage, state of resistance (SOR) i.e., internal impedance, and optionally temperature of the electrical energy storage cells. The propulsion electrical energy storage 302 may be a Li-ion electrical energy storage comprising multiple cells electrically connected in series and/or in parallel.

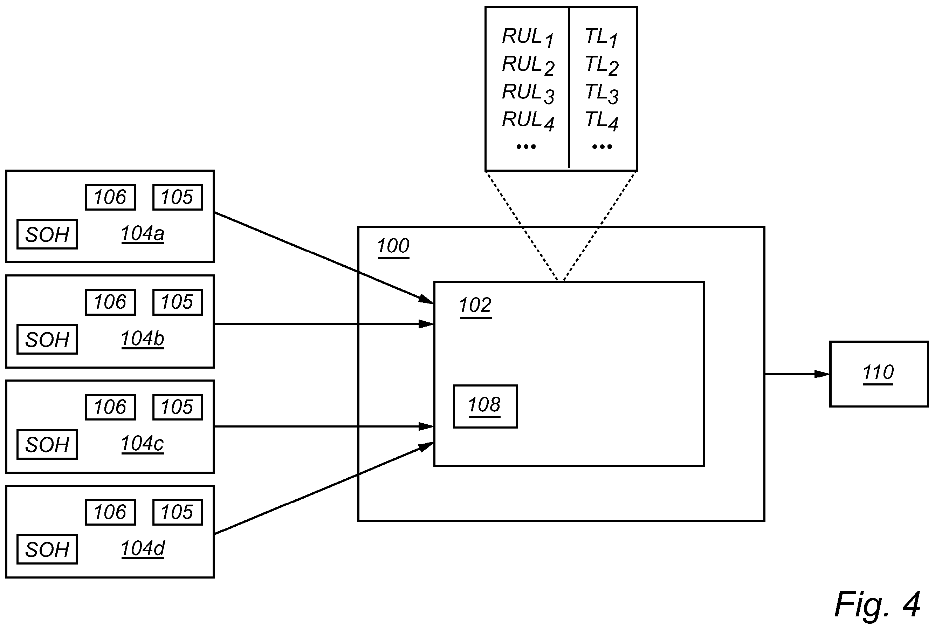

**FIG. 4** is another view of **FIG. 1****,** according to an example. A computer system 100 for improving utilization of electrical energy storage packs 104a-d, the system 100 comprising processing circuitry 102 configured to: determine a present state of health SOH of each of the electrical energy storage packs 104a-d. Determine a present aging rate of the electrical energy storage packs 104a-d based on historical usage pattern data 106 of the respective electrical energy storage pack 104a-d. Predict remaining useful life RUL for the respective electrical energy storage pack 104a-d based on a difference between the present state of health SOH and a lower state of health threshold/limit TL, and the determined aging rate of the respective electrical energy storage pack 104a-d. Compare the remaining useful life RUL to a lifetime target TL for each electrical energy storage pack 104a-d, wherein: if the predicted remaining useful life RUL is below the lifetime target TL by more than a first predetermined margin, determine that the electrical energy storage pack 104a-d is over-utilized, and if the predicted remaining useful life RUL exceeds the lifetime target TL by more than a second predetermined margin, determine that the electrical energy storage pack 104a-d is under-utilized. Provide output data 108 indicating the electrical energy storage packs which are over-utilized, and the electrical energy storage packs which are under-utilized, and their respective state of health's. Determine an electrical energy pack storage pack strategy for the over-utilized and under-utilized electrical energy storage packs, the strategy is subject to a predetermined utilization objective, and provide an output message 110 indicating the electrical energy storage pack strategy.

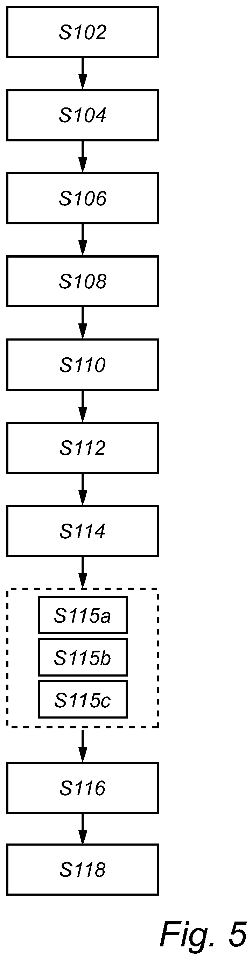

**FIG. 5** is a flow chart of a method for improving utilization of electrical energy storage packs according to an example.

In step S102, determining, by processing circuitry of a computer system, a present state of health (SOH) of each of the electrical energy storage packs.

In step S104, determining, by the processing circuitry, a present aging rate of the electrical energy storage packs based on historical usage pattern data of the respective electrical energy storage pack.

In step S106, predicting, by the processing circuitry, remaining useful life for the respective electrical energy storage pack based on a difference between the present state of health and a lower state of health threshold/limit, and the determined aging rate of the respective electrical energy storage pack.

In step S108, comparing, by the processing circuitry, the remaining useful life to a lifetime target for each electrical energy storage pack.

If the predicted remaining useful life is below the lifetime target by more than a first predetermined margin, determining in step S110, by the processing circuitry, that the electrical energy storage pack is over-utilized.

If the predicted remaining useful life exceeds the lifetime target by more than a second predetermined margin, determining in step S112, by the processing circuitry, that the electrical energy storage pack is under-utilized.

In step S114, providing, by the processing circuitry, output data indicating the electrical energy storage packs which are over-utilized, and the electrical energy storage packs which are under-utilized, and their respective state of health's.

In step S116, determining, by the processing circuitry, an electrical energy pack storage pack strategy for the over-utilized and under-utilized electrical energy storage packs, the strategy is subject to a predetermined utilization objective.

In step S118, providing, by the processing circuitry, an output message indicating the electrical energy storage pack strategy.

Optionally, determining in step S115a, by the processing circuitry, a first predicted remaining useful life for the over-utilized and under-utilized electrical energy storage packs in their present applications.

In step S115b, determining, by the processing circuitry, a second predicted remaining useful life for the over-utilized and under-utilized electrical energy storage packs in at least one other application,
In step S115b, comparing, by the processing circuitry, the first predicted remaining useful lives and the second predicted remaining useful lives.

When including optional steps S115a-c, determining in step S116, by the processing circuitry, the electrical energy storage pack strategy further based on the comparison.

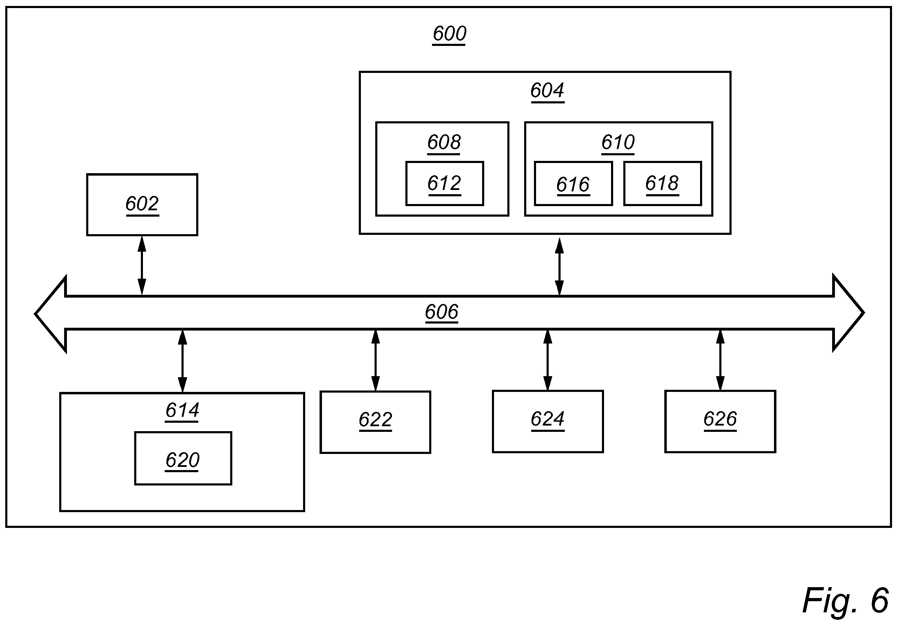

**FIG. 6** is a schematic diagram of a computer system **600** for implementing examples disclosed herein. The computer system **600** is adapted to execute instructions from a computer-readable medium to perform these and/or any of the functions or processing described herein. The computer system **600** may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system 600 may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **600** may comprise at least one computing device or electronic device capable of including firmware, hardware, and/or executing software instructions to implement the functionality described herein. The computer system **600** may include processing circuitry **602** (e.g., processing circuitry including one or more processor devices or control units), a memory **604,** and a system bus **606.** The computer system **600** may include at least one computing device having the processing circuitry **602.** The system bus **606** provides an interface for system components including, but not limited to, the memory **604** and the processing circuitry **602.** The processing circuitry **602** may include any number of hardware components for conducting data or signal processing or for executing computer code stored in memory **604.** The processing circuitry **602** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **602** may further include computer executable code that controls operation of the programmable device.

The system bus **606** may be any of several types of bus structures that may further interconnect to a memory bus (with or without a memory controller), a peripheral bus, and/or a local bus using any of a variety of bus architectures. The memory **604** may be one or more devices for storing data and/or computer code for completing or facilitating methods described herein. The memory **604** may include database components, object code components, script components, or other types of information structure for supporting the various activities herein. Any distributed or local memory device may be utilized with the systems and methods of this description. The memory **604** may be communicably connected to the processing circuitry **602** (e.g., via a circuit or any other wired, wireless, or network connection) and may include computer code for executing one or more processes described herein. The memory **604** may include non-volatile memory **608** (e.g., read-only memory (ROM), erasable programmable read-only memory (EPROM), electrically erasable programmable read-only memory (EEPROM), etc.), and volatile memory **610** (e.g., random-access memory (RAM)), or any other medium which can be used to carry or store desired program code in the form of machine-executable instructions or data structures and which can be accessed by a computer or other machine with processing circuitry **602.** A basic input/output system (BIOS) **612** may be stored in the non-volatile memory **608** and can include the basic routines that help to transfer information between elements within the computer system **600.**

The computer system **600** may further include or be coupled to a non-transitory computer-readable storage medium such as the storage device **614,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **614** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **614** and/or in the volatile memory **610,** which may include an operating system **616** and/or one or more program modules **618.** All or a portion of the examples disclosed herein may be implemented as a computer program **620** stored on a transitory or non-transitory computer-usable or computer-readable storage medium (e.g., single medium or multiple media), such as the storage device **614,** which includes complex programming instructions (e.g., complex computer-readable program code) to cause the processing circuitry **602** to carry out actions described herein. Thus, the computer-readable program code of the computer program **620** can comprise software instructions for implementing the functionality of the examples described herein when executed by the processing circuitry **602.** In some examples, the storage device **614** may be a computer program product (e.g., readable storage medium) storing the computer program **620** thereon, where at least a portion of a computer program **620** may be loadable (e.g., into a processor) for implementing the functionality of the examples described herein when executed by the processing circuitry **602.** The processing circuitry **602** may serve as a controller or control system for the computer system **600** that is to implement the functionality described herein.

The computer system **600** may include an input device interface **622** configured to receive input and selections to be communicated to the computer system **600** when executing instructions, such as from a keyboard, mouse, touch-sensitive surface, etc. Such input devices may be connected to the processing circuitry **602** through the input device interface **622** coupled to the system bus **606** but can be connected through other interfaces, such as a parallel port, an Institute of Electrical and Electronic Engineers (IEEE) 1394 serial port, a Universal Serial Bus (USB) port, an IR interface, and the like. The computer system **600** may include an output device interface **624** configured to forward output, such as to a display, a video display unit (e.g., a liquid crystal display (LCD) or a cathode ray tube (CRT)). The computer system **600** may include a communications interface **626** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software as defined by the appended claims.

## Claims

1. A computer system (100) for improving utilization of electrical energy storage packs (104a-d) where at least a portion of the electrical energy storage packs are utilized in electrified vehicles, the system comprising processing circuitry configured to:
determine a present state of health (SOH) of each of the electrical energy storage packs,
determine a present aging rate of the electrical energy storage packs based on historical usage pattern data (106) of the respective electrical energy storage pack,
predict remaining useful life (RUL) for the respective electrical energy storage pack based on a difference between the present state of health and a lower state of health threshold/limit below which target performance requirements for a present application of the respective electrical energy storage pack are not met, and the determined aging rate of the respective electrical energy storage pack,
compare the remaining useful life to a lifetime target (TL) for each electrical energy storage pack, wherein:
if the predicted remaining useful life is below the lifetime target by more than a first predetermined margin, determine that the electrical energy storage pack is over-utilized, and
if the predicted remaining useful life exceeds the lifetime target by more than a second predetermined margin, determine that the electrical energy storage pack is under-utilized,
provide output data (108) indicating the electrical energy storage packs which are over-utilized, and the electrical energy storage packs which are under-utilized, and their respective state of health's,
determine an electrical energy pack storage pack strategy for the over-utilized and under-utilized electrical energy storage packs including distributing the electrical energy storage packs (104a-d) in different vehicles or in different secondary applications such that the predetermined utilization objective is fulfilled as closely as possible, the strategy is subject to a predetermined utilization objective, and
provide an output message (110) indicating the electrical energy storage pack strategy (111).

2. The computer system of claim 1, wherein the predetermined utilization objective is to minimize aging rate for the electrical energy storage packs.

3. The computer system of any of claims 1-2, wherein the predetermined utilization objective is to maximize the lifetime of the electrical energy storage packs.

4. The computer system of claim 3, wherein lifetime is in units of time or in units of total energy throughput.

5. The computer system of any of claims 1-4, wherein the predetermined utilization objective is to minimize the remaining allowable capacity fade at the end of a predetermined time duration.

6. The computer system of any of claims 1-4, wherein the predetermined utilization objective is to minimize the remaining allowable increase in internal resistance at the end of a predetermined time duration.

7. The computer system of any of claims 5 and 6, wherein the predetermined utilization objective is to minimize a weighted sum of the remaining allowable increase in internal resistance and the remaining allowable capacity fade at the end of the predetermined time duration.

8. A server comprising the computer system of any of claims 1-7.

9. A computer-implemented method for improving utilization of electrical energy storage packs where at least a portion of the electrical energy storage packs are utilized in electrified vehicles, comprising:
determining (S102), by processing circuitry of a computer system, a present state of health (SOH) of each of the electrical energy storage packs,
determining (S104), by the processing circuitry, a present aging rate of the electrical energy storage packs based on historical usage pattern data of the respective electrical energy storage pack,
predicting (S106), by the processing circuitry, remaining useful life for the respective electrical energy storage pack based on a difference between the present state of health and a lower state of health threshold/limit below which target performance requirements for a present application of the respective electrical energy storage pack are not met, and the determined aging rate of the respective electrical energy storage pack,
comparing (S108), by the processing circuitry, the remaining useful life to a lifetime target for each electrical energy storage pack, wherein:
if the predicted remaining useful life is below the lifetime target by more than a first predetermined margin, determining (S110), by the processing circuitry, that the electrical energy storage pack is over-utilized, and
if the predicted remaining useful life exceeds the lifetime target by more than a second predetermined margin, determining (S112), by the processing circuitry, that the electrical energy storage pack is under-utilized,
providing (S114), by the processing circuitry, output data indicating the electrical energy storage packs which are over-utilized, and the electrical energy storage packs which are under-utilized, and their respective state of health's,
determining (S116), by the processing circuitry, an electrical energy pack storage pack strategy for the over-utilized and under-utilized electrical energy storage packs including distributing the electrical energy storage packs (104a-d) in different vehicles or in different secondary applications such that the predetermined utilization objective is fulfilled as closely as possible, the strategy is subject to a predetermined utilization objective, and
providing (S118), by the processing circuitry, an output message indicating the electrical energy storage pack strategy.

10. The method of claim 9, wherein the predetermined utilization objective is to minimize aging rate for the electrical energy storage packs.

11. The method of any of claims 9-10, wherein the predetermined utilization objective is to maximize the lifetime of the electrical energy storage packs.

12. The method of claims 9-11, wherein determining the electrical energy pack storage pack strategy comprises:
determining (S115a), by the processing circuitry, a first predicted remaining useful life for the over-utilized and under-utilized electrical energy storage packs in their present applications,
determining (S115b), by the processing circuitry, a second predicted remaining useful life for the over-utilized and under-utilized electrical energy storage packs in at least one other application,
comparing (S115c), by the processing circuitry, the first predicted remaining useful lives and the second predicted remaining useful lives, and
determining (S116), by the processing circuitry, the electrical energy storage pack strategy based on the comparison.

13. The method of claim 12, comprising:
determining, by the processing circuitry, the electrical energy storage pack strategy for a current application with the predetermined utilization objective to minimize a weighted sum of the remaining allowable increase in internal resistance and the remaining allowable capacity fade at the end of the predetermined time duration, for the electrical energy storage packs.

14. A computer program product (140) comprising program code for performing, when executed by the processing circuitry, the method of any of claims 9-13.

15. A non-transitory computer-readable storage medium (142) comprising instructions, which when executed by the processing circuitry, cause the processing circuitry to perform the method of any of claims 9-13.

## Patentansprüche

1. Computersystem (100) zum Verbessern der Nutzung von elektrischen Energiespeicherpacks (104a-d), wobei mindestens ein Teil der elektrischen Energiespeicherpacks in elektrifizierten Fahrzeugen genutzt wird, wobei das System einen Verarbeitungsschaltkreis umfasst, der für Folgendes konfiguriert ist:
Bestimmen eines gegenwärtigen Gesundheitszustands (SOH) jedes der elektrischen Energiespeicherpacks,
Bestimmen einer gegenwärtigen Alterungsrate der elektrischen Energiespeicherpacks basierend auf historischen Nutzungsmusterdaten (106) des jeweiligen elektrischen Energiespeicherpacks,
Vorhersagen einer verbleibenden Nutzungsdauer (RUL) für das jeweilige elektrische Energiespeicherpack basierend auf einer Differenz zwischen dem gegenwärtigen Gesundheitszustand und einem unteren Schwellenwert/Grenzwert des Gesundheitszustands, unterhalb dessen die Ziel-Leistungsanforderungen für eine gegenwärtige Anwendung des jeweiligen elektrischen Energiespeicherpacks nicht erfüllt werden, und der bestimmten Alterungsrate des jeweiligen elektrischen Energiespeicherpacks,
Vergleichen der verbleibenden Nutzungsdauer mit einem Lebensdauerziel (TL) für jedes elektrische Energiespeicherpack, wobei:
wenn die vorhergesagte verbleibende Nutzungsdauer um mehr als eine erste vorbestimmte Spanne unter dem Lebensdauerziel liegt, Bestimmen, dass das elektrische Energiespeicherpack übermäßig genutzt wird, und
wenn die vorhergesagte verbleibende Nutzungsdauer um mehr als eine zweite vorbestimmte Spanne über dem Lebensdauerziel liegt, Bestimmen, dass das elektrische Energiespeicherpack zu wenig genutzt wird,
Bereitstellen von Ausgangsdaten (108), die die elektrischen Energiespeicherpacks, die übermäßig genutzt werden, und die elektrischen Energiespeicherpacks, die zu wenig genutzt werden, sowie deren jeweiligen Gesundheitszustand angeben,
Bestimmen einer Strategie für die elektrischen Energiespeicherpacks für die übermäßig genutzten und die zu wenig genutzten elektrischen Energiespeicherpacks einschließlich des Verteilens der elektrischen Energiespeicherpacks (104a-d) auf verschiedene Fahrzeuge oder verschiedene Sekundäranwendungen, so dass das vorbestimmte Auslastungsziel so weit wie möglich erreicht wird, wobei die Strategie einem vorbestimmten Auslastungsziel unterliegt, und
Bereitstellen einer Ausgangsnachricht (110), die die Strategie für die elektrischen Energiespeicherpacks (111) angibt.

2. Computersystem nach Anspruch 1, wobei das vorbestimmte Auslastungsziel die Alterungsrate für die elektrischen Energiespeicherpacks minimieren soll.

3. Computersystem nach einem der Ansprüche 1-2, wobei das vorbestimmte Auslastungsziel die Lebensdauer der elektrischen Energiespeicherpacks maximieren soll.

4. Computersystem nach Anspruch 3, wobei die Lebensdauer in Zeiteinheiten oder in Einheiten des gesamten Energiedurchsatzes ausgedrückt wird.

5. Computersystem nach einem der Ansprüche 1-4, wobei das vorbestimmte Auslastungsziel den verbleibenden zulässigen Kapazitätsverlust am Ende einer vorbestimmten Zeitdauer minimieren soll.

6. Computersystem nach einem der Ansprüche 1-4, wobei das vorbestimmte Auslastungsziel den verbleibenden zulässigen Anstieg des Innenwiderstands am Ende einer vorbestimmten Zeitdauer minimieren soll.

7. Computersystem nach einem der Ansprüche 5 und 6, wobei das vorbestimmte Auslastungsziel eine gewichtete Summe aus dem verbleibenden zulässigen Anstieg des Innenwiderstands und dem verbleibenden zulässigen Kapazitätsverlust am Ende der vorbestimmten Zeitdauer minimieren soll.

8. Server, der das Computersystem nach einem der Ansprüche 1-7 umfasst.

9. Computerimplementiertes Verfahren zum Verbessern der Nutzung von elektrischen Energiespeicherpacks, wobei mindestens ein Teil der elektrischen Energiespeicherpacks in elektrifizierten Fahrzeugen genutzt wird, umfassend:
Bestimmen (S102), durch einen Verarbeitungsschaltkreis eines Computersystems, eines gegenwärtigen Gesundheitszustands (SOH) jedes der elektrischen Energiespeicherpacks,
Bestimmen (S104), durch den Verarbeitungsschaltkreis, einer gegenwärtigen Alterungsrate der elektrischen Energiespeicherpacks basierend auf historischen Nutzungsmusterdaten des jeweiligen elektrischen Energiespeicherpacks,
Vorhersagen (S106), durch den Verarbeitungsschaltkreis, einer verbleibenden Nutzungsdauer für das jeweilige elektrische Energiespeicherpack basierend auf einer Differenz zwischen dem gegenwärtigen Gesundheitszustand und einem unteren Schwellenwert/Grenzwert des Gesundheitszustands, unterhalb dessen die Ziel-Leistungsanforderungen für eine gegenwärtige Anwendung des jeweiligen elektrischen Energiespeicherpacks nicht erfüllt werden, und der bestimmten Alterungsrate des jeweiligen elektrischen Energiespeicherpacks,
Vergleichen (S108), durch den Verarbeitungsschaltkreis, der verbleibenden Nutzungsdauer mit einem Lebensdauerziel für jedes elektrische Energiespeicherpack, wobei:
wenn die vorhergesagte verbleibende Nutzungsdauer um mehr als eine erste vorbestimmte Spanne unter dem Lebensdauerziel liegt, Bestimmen (S110) durch den Verarbeitungsschaltkreis, dass das elektrische Energiespeicherpack übermäßig genutzt wird, und
wenn die vorhergesagte verbleibende Nutzungsdauer um mehr als eine zweite vorbestimmte Spanne über dem Lebensdauerziel liegt, Bestimmen (S112) durch den Verarbeitungsschaltkreis, dass das elektrische Energiespeicherpack zu wenig genutzt wird,
Bereitstellen (S114), durch den Verarbeitungsschaltkreis, von Ausgangsdaten, die die elektrischen Energiespeicherpacks, die übermäßig genutzt werden, und die elektrischen Energiespeicherpacks, die zu wenig genutzt werden, sowie deren jeweiligen Gesundheitszustand angeben,
Bestimmen (S116), durch den Verarbeitungsschaltkreis, einer Strategie für die elektrischen Energiespeicherpacks für die übermäßig genutzten und die zu wenig genutzten elektrischen Energiespeicherpacks einschließlich des Verteilens der elektrischen Energiespeicherpacks (104a-d) auf verschiedene Fahrzeuge oder verschiedene Sekundäranwendungen, so dass das vorbestimmte Auslastungsziel so weit wie möglich erreicht wird, wobei die Strategie einem vorbestimmten Auslastungsziel unterliegt, und
Bereitstellen (S118), durch den Verarbeitungsschaltkreis, einer Ausgangsnachricht, die die Strategie für die elektrischen Energiespeicherpacks angibt.

10. Verfahren nach Anspruch 9, wobei das vorbestimmte Auslastungsziel die Alterungsrate für die elektrischen Energiespeicherpacks minimieren soll.

11. Verfahren nach einem der Ansprüche 9-10, wobei das vorbestimmte Auslastungsziel die Lebensdauer der elektrischen Energiespeicherpacks maximieren soll.

12. Verfahren nach den Ansprüchen 9-11, wobei das Bestimmen der Strategie für die elektrischen Energiespeicherpacks Folgendes umfasst:
Bestimmen (S115a), durch den Verarbeitungsschaltkreis, einer ersten vorhergesagten verbleibenden Nutzungsdauer für die übermäßig genutzten und die zu wenig genutzten elektrischen Energiespeicherpacks in ihren gegenwärtigen Anwendungen,
Bestimmen (S115b), durch den Verarbeitungsschaltkreis, einer zweiten vorhergesagten verbleibenden Nutzungsdauer für die übermäßig genutzten und die zu wenig genutzten elektrischen Energiespeicherpacks in mindestens einer weiteren Anwendung,
Vergleichen (S115c), durch den Verarbeitungsschaltkreis, der ersten vorhergesagten verbleibenden Nutzungsdauern und der zweiten vorhergesagten verbleibenden Nutzungsdauern, und
Bestimmen (S116), durch den Verarbeitungsschaltkreis, der Strategie für die elektrischen Energiespeicherpacks basierend auf dem Vergleich.

13. Verfahren nach Anspruch 12, umfassend:
Bestimmen, durch den Verarbeitungsschaltkreis, der Strategie für die elektrischen Energiespeicherpacks für eine aktuelle Anwendung mit dem vorbestimmten Auslastungsziel, um eine gewichtete Summe aus dem verbleibenden zulässigen Anstieg des Innenwiderstands und dem verbleibenden zulässigen Kapazitätsverlust am Ende der vorbestimmten Zeitdauer zu minimieren, für die elektrischen Energiespeicherpacks.

14. Computerprogrammprodukt (140), das einen Programmcode zum Durchführen des Verfahrens nach einem der Ansprüche 9-13 umfasst, wenn er vom Verarbeitungsschaltkreis ausgeführt wird.

15. Nichtflüchtiges, computerlesbares Speichermedium (142), das Anweisungen umfasst, die, wenn sie vom Verarbeitungsschaltkreis ausgeführt werden, den Verarbeitungsschaltkreis dazu veranlassen, das Verfahren nach einem der Ansprüche 9-13 durchzuführen.

## Revendications

1. Système informatique (100) permettant d'améliorer l'utilisation de packs de stockage d'énergie électrique (104a-d), au moins une partie des packs de stockage d'énergie électrique étant utilisée dans des véhicules électrifiés, le système comprenant des circuits de traitement configurés pour :
déterminer un état de santé actuel (SOH) de chacun des packs de stockage d'énergie électrique,
déterminer un taux de vieillissement actuel des packs de stockage d'énergie électrique sur la base de données historiques de modèle d'utilisation (106) du pack de stockage d'énergie électrique respectif,
prévoir la durée de vie utile restante (RUL) du pack de stockage d'énergie électrique respectif sur la base d'une différence entre l'état de santé actuel et un seuil/une limite d'état de santé inférieur en dessous duquel ou de laquelle les exigences de performance cibles pour une application actuelle du pack de stockage d'énergie électrique respectif ne sont pas respectées, et le taux de vieillissement déterminé du pack de stockage d'énergie électrique respectif,
comparer la durée de vie utile restante à un objectif de durée de vie (TL) pour chaque pack de stockage d'énergie électrique :
si la durée de vie utile restante prévue est inférieure à la durée de vie cible à raison de plus d'une première marge prédéterminée, déterminer que le pack de stockage d'énergie électrique est surutilisé, et
si la durée de vie utile restante prévue dépasse la durée de vie cible à raison de plus d'une seconde marge prédéterminée, déterminer que le pack de stockage d'énergie électrique est sous-utilisé,
fournir des données de sortie (108) indiquant les packs de stockage d'énergie électrique qui sont surutilisés et les packs de stockage d'énergie électrique qui sont sous-utilisés, ainsi que leur état de santé respectif,
déterminer une stratégie de pack de stockage d'énergie électrique pour les packs de stockage d'énergie électrique surutilisés et sous-utilisés, y compris la répartition des packs de stockage d'énergie électrique (104a-d) dans différents véhicules ou dans différentes applications secondaires de sorte que l'objectif d'utilisation prédéterminé soit atteint aussi étroitement que possible, la stratégie étant soumise à un objectif d'utilisation prédéterminé, et
émettre un message de sortie (110) indiquant la stratégie du pack de stockage d'énergie électrique (111).

2. Système informatique selon la revendication 1, dans lequel l'objectif d'utilisation prédéterminé est de minimiser le taux de vieillissement des packs de stockage d'énergie électrique.

3. Système informatique selon l'une quelconque des revendications 1 et 2, dans lequel l'objectif d'utilisation prédéterminé est de maximiser la durée de vie des packs de stockage d'énergie électrique.

4. Système informatique selon la revendication 3, dans lequel la durée de vie est exprimée en unités de temps ou en unités de débit d'énergie total.

5. Système informatique selon l'une quelconque des revendications 1 à 4, dans lequel l'objectif d'utilisation prédéterminé est de minimiser l'affaiblissement de capacité admissible restant à la fin d'une durée prédéterminée.

6. Système informatique selon l'une quelconque des revendications 1 à 4, dans lequel l'objectif d'utilisation prédéterminé est de minimiser l'augmentation admissible restante de la résistance interne à la fin d'une durée prédéterminée.

7. Système informatique selon l'une quelconque des revendications 5 et 6, dans lequel l'objectif d'utilisation prédéterminé est de minimiser une somme pondérée de l'augmentation admissible restante de la résistance interne et de l'affaiblissement de capacité admissible à la fin de la durée prédéterminée.

8. Serveur comprenant le système informatique selon l'une quelconque des revendications 1 à 7.

9. Procédé mis en œuvre par ordinateur pour améliorer l'utilisation de packs de stockage d'énergie électrique, dans lequel au moins une partie des packs de stockage d'énergie électrique est utilisée dans des véhicules électrifiés, comprenant :
la détermination (S102), au moyen de circuits de traitement d'un système informatique, d'un état de santé actuel (SOH) de chacun des packs de stockage d'énergie électrique,
la détermination (S104), au moyen des circuits de traitement, d'un taux de vieillissement actuel des packs de stockage d'énergie électrique sur la base de données historiques de modèle d'utilisation du pack de stockage d'énergie électrique respectif,
la prévision (S106), par les circuits de traitement, de la durée de vie utile restante du pack de stockage d'énergie électrique respectif sur la base d'une différence entre l'état de santé actuel et un seuil/une limite d'état de santé inférieur en dessous duquel ou de laquelle les exigences de performance cibles pour une application actuelle du pack de stockage d'énergie électrique respectif ne sont pas satisfaites, et du taux de vieillissement déterminé du pack de stockage d'énergie électrique respectif,
comparer (S108), par les circuits de traitement, la durée de vie utile restante à une durée de vie cible pour chaque pack de stockage d'énergie électrique :
si la durée de vie utile restante prévue est inférieure à la durée de vie cible à raison de plus d'une première marge prédéterminée, déterminer (S110), par les circuits de traitement, que le pack de stockage d'énergie électrique est surutilisé, et
si la durée de vie utile restante prévue dépasse la durée de vie cible de plus d'une seconde marge prédéterminée, déterminer (S112), par les circuits de traitement, que le pack de stockage d'énergie électrique est sous-utilisé,
fournir (S114), par les circuits de traitement, des données de sortie indiquant les packs de stockage en énergie électrique qui sont surutilisés, et les packs de stockage en énergie électrique qui sont sous-utilisés, ainsi que leur état de santé respectif,
déterminer (S116), par les circuits de traitement, une stratégie de stockage d'énergie électrique pour les packs de stockage d'énergie électrique surutilisés et sous-utilisés, y compris la répartition des packs de stockage d'énergie électrique (104a-d) dans différents véhicules ou dans différentes applications secondaires, de sorte que l'objectif d'utilisation prédéterminé soit atteint le plus fidèlement possible, la stratégie étant subordonnée à un objectif d'utilisation prédéterminé, et
émettre (S118), par les circuits de traitement, un message de sortie indiquant la stratégie du pack de stockage d'énergie électrique.

10. Procédé selon la revendication 9, dans lequel l'objectif d'utilisation prédéterminé est de minimiser le taux de vieillissement des packs de stockage d'énergie.

11. Procédé selon l'une quelconque des revendications 9 à 10, dans lequel l'objectif d'utilisation prédéterminé est de maximiser la durée de vie des packs de stockage d'énergie électrique.

12. Procédé selon les revendications 9 à 11, dans lequel la détermination de la stratégie du pack de stockage d'énergie électrique comprend :
la détermination (S115a), au moyen des circuits de traitement, d'une première durée de vie utile restante prévue pour les packs de stockage d'énergie électrique surutilisés et sous-utilisés dans leurs applications actuelles,
la détermination (S115b), au moyen des circuits de traitement, d'une seconde durée de vie utile restante prévue pour les packs de stockage d'énergie électrique surutilisés et sous-utilisés dans au moins une autre application,
la comparaison (S115c), par les circuits de traitement, de la première durée de vie utile restante prévue et de la seconde durée de vie utile restante prévue, et
la détermination (S116), par les circuits de traitement, de la stratégie du pack de stockage d'énergie électrique sur la base de la comparaison.

13. Procédé selon la revendication 12, comprenant :
la détermination, par les circuits de traitement, de la stratégie de pack de stockage d'énergie électrique pour une application actuelle avec l'objectif d'utilisation prédéterminé pour minimiser une somme pondérée de l'augmentation restante admissible de la résistance interne et de l'affaiblissement de capacité restante admissible à la fin de la durée prédéterminée, pour les packs de stockage d'énergie électrique.

14. Produit de programme informatique (140) comprenant un code de programme pour exécuter, lorsqu'il est exécuté par les circuits de traitement, le procédé selon l'une quelconque des revendications 9 à 13.

15. Support de stockage non transitoire lisible par ordinateur (142) comprenant des instructions qui, lorsqu'elles sont exécutées par les circuits de traitement, amènent les circuits de traitement à exécuter le procédé selon l'une quelconque des revendications 9 à 13.
